# EUROPEAN PATENT APPLICATION

(11) **EP 4 818 598 A1**
(43) Date of publication of application: **07.10.2026**
(21) Application number: 26153617.1
(22) Date of filing: 22.01.2026
(51) Int. Cl.: F25B 25/00, F01K 13/02, F01K 25/08, F25B 41/20, F25B 49/02, H05K 7/20

(54) **COOLING SYSTEM AND METHOD OF OPERATING A COOLING SYSTEM**

(30) Priority: 17.03.2025 US 202519081287
(71) Applicant: Schneider Electric IT Corporation, Foxboro, MA 02035 (US)
(72) Inventor: SHEEHAN, Stuart Michael, FOXBORO, 02035 (US)
(74) Representative: Lavoix

(57) **Abstract**

A cooling system (CS) includes a first heat exchanger (HE) having a first inlet and a first outlet and configured to be coupled to a facility-cooling loop; a second HE having a second inlet and a second outlet; an expansion valve (EV) having an EV inlet and an EV outlet; a pump having a pump inlet and a pump outlet; and an expander having a first flow terminal (FT) and a second FT, wherein in a first CS operating mode, the pump inlet is coupled to the first outlet, the pump outlet is coupled to the second inlet, the first FT is coupled to the second outlet, the second FT is coupled to the first inlet, and the expander is configured to convert heat into electric power, and in a second CS operating mode, the EV inlet is coupled to the first outlet, the EV outlet is coupled to the second inlet, the first FT is coupled to the first inlet, the second FT is coupled to the second outlet, and the expander is configured to operate as a compressor to provide cooling.

## Description

### BACKGROUND

### 1. Field of the Disclosure

At least one example in accordance with the present disclosure relates generally to cooling systems.

### 2. Discussion of Related Art

Cooling systems, such as liquid cooling systems, may be used to provide cooling to various heat-generating and temperature-sensitive objects, such as IT equipment in data centers. A liquid cooling system may include one or more coolant distribution units (CDUs) to provide primary cooling and/or trim cooling to supplement the primary cooling. CDUs may distribute and regulate a coolant, such as water or other working fluids, to various parts of a machine or process that require cooling for temperature control. Generally speaking, a trim cooler may include a water-cooled heat exchanger, which is used in addition to an air-cooled heat exchanger. When ambient air temperatures cannot cool the working fluid to the desired temperature, a combination of air-cooled and water-cooled trim cooler can be used.

### SUMMARY

Examples of the methods and systems discussed herein are not limited in application to the details of construction and the arrangement of components set forth in the following description or illustrated in the accompanying drawings. The methods and systems may be capable of implementation in other embodiments and of being practiced or of being carried out in various ways. Examples of specific implementations are provided herein for illustrative purposes and are not intended to be limiting. Acts, components, elements, and features discussed in connection with any one or more examples may be configured to operate and/or be implemented in a similar role in any other examples.

The phraseology and terminology used herein is for the purpose of description. References to examples, embodiments, components, elements, or acts of the systems and methods herein referred to in the singular may also embrace embodiments including a plurality. Similarly, references in plural to embodiments, components, elements, or acts may be implemented as a singularity. References in the singular or plural form may therefore not be intended to limit the presently disclosed systems or methods, their components, acts, or elements. The use herein of "including," "comprising," "having," "containing," "involving," and variations so forth, may encompass the items listed thereafter and equivalents thereof as well as additional items.

References to "or" may be construed as inclusive so that any terms described using "or" may indicate any of a single, more than one, and all of the described terms. For example, the phrase "at least one of A or B" may refer A and/or B-that is, A only, B only, or A and B together. In addition, in the event of inconsistent usages of terms between this document and documents incorporated herein by reference, the term usage in the incorporated documents is supplementary to this document. For irreconcilable differences, the term usage in this document controls.

According to at least one aspect of the present disclosure, in one example, a cooling system is disclosed. The cooling system includes a first heat exchanger including a first inlet and a first outlet, the first heat exchanger configured to be coupled to a facility-cooling loop; a second heat exchanger including a second inlet and a second outlet; an expansion valve including an expansion-valve inlet and an expansion-valve outlet; a pump including a pump inlet and a pump outlet; and an expander including a first flow terminal and a second flow terminal, wherein in a first operating mode of the cooling system, the pump inlet is coupled to the first outlet, the pump outlet is coupled to the second inlet, the first flow terminal is coupled to the second outlet, the second flow terminal is coupled to the first inlet, and the expander is configured to convert heat into electric power, and in a second operating mode of the cooling system, the expansion-valve inlet is coupled to the first outlet, the expansion-valve outlet is coupled to the second inlet, the first flow terminal is coupled to the first inlet, the second flow terminal is coupled to the second outlet, and the expander is configured to operate as a compressor to provide cooling.

In one example of the cooling system, the cooling system is configured to use an Organic Rankine Cycle (ORC) in the first operating mode. In one example of the cooling system, using an ORC in the first operating mode includes using an organic working fluid. In one example of the cooling system, the organic working fluid includes at least one of a group including chlorofluorocarbons (CFCs), hydrochlorofluorocarbons (HCFCs), hydrofluorocarbons (HFCs), hydrocarbons (HCs), and perfluorocarbons (PFCs). In another example of the cooling system, the cooling system is configured to use the organic working fluid in the second operating mode. In yet another example of the cooling system, the cooling system is configured to use an inorganic working fluid in the second operating mode.

In one example of the cooling system, the facility-cooling loop is a free-cooling loop, and the cooling system is configured to operate in the first operating mode in response to an inlet temperature of a working fluid of the free-cooling loop below a threshold temperature. In one example of the cooling system, the cooling system is configured to operate in the second operating mode in response to the inlet temperature of the working fluid of the free-cooling loop above the threshold temperature. In one example of the cooling system, the inlet temperature of the working fluid of the free-cooling loop is determined by an ambient temperature of the free-cooling loop. In another example of the cooling system, the cooling system further includes a plurality of switching valves and at least one controller, wherein the at least one controller is configured to control the plurality of switching valves in a first configuration in response to the inlet temperature of the working fluid of the free-cooling loop below the threshold temperature.

In one example of the cooling system, controlling the plurality of switching valves in the first configuration includes: controlling a first switching valve of the plurality of switching valves to couple the pump inlet to the first outlet; controlling a second switching valve of the plurality of switching valves to couple the pump outlet to the second inlet; controlling a third switching valve of the plurality of switching valves to couple the first flow terminal to the second outlet; and controlling a fourth switching valve of the plurality of switching valves to couple the second flow terminal to the first inlet.

In another example of the cooling system, the at least one controller is configured to control the plurality of switching valves in a second configuration in response to the inlet temperature of the working fluid of the free-cooling loop above the threshold temperature. In one example of the cooling system, controlling the plurality of switching valves in the second configuration includes: controlling the first switching valve to couple the expansion-valve inlet to the first outlet; controlling the second switching valve to couple the expansion-valve outlet to the second inlet; controlling the third switching valve to couple the first flow terminal to the first outlet; and controlling the fourth switching valve to couple the second flow terminal to the second inlet.

In one example of the cooling system, the second heat exchanger is configured to be coupled to an equipment cooling loop, the equipment-cooling loop being configured to cool IT equipment in a data center. In one example of the cooling system, the cooling system is configured to provide supplementary trim cooling of the IT equipment in the second operating mode.

In one example of the cooling system, the second heat exchanger is configured to be coupled to IT equipment in a data center to provide cooling.

According to at least another aspect of the present disclosure, in one example, a method of operating a cooling system is disclosed. The method includes coupling a first heat exchanger of the cooling system to a facility-cooling loop, the first heat exchanger including a first inlet and a first outlet; coupling a second heat exchanger of the cooling system to an equipment-cooling loop or IT equipment, the second heat exchanger including a second inlet and a second outlet; operating the cooling system in a first mode, including coupling an inlet of a pump of the cooling system to the first outlet, coupling an outlet of the pump to the second inlet, coupling a first flow terminal of an expander of the cooling system to the second outlet, coupling a second flow terminal of the expander to the first inlet, and operating the expander to convert heat into electrical power; and operating the cooling system in a second mode, including coupling an expansion-valve inlet of an expansion valve of the cooling system to the first outlet, coupling an expansion-valve outlet of the expansion valve to the second inlet, coupling the first flow terminal to the first inlet, coupling the second flow terminal to the second outlet, and operating the expander as a compressor to provide cooling.

In one example of the method, operating the cooling system in the first mode further comprises using an Organic Rankine Cycle (ORC).

In another example of the method, the facility-cooling loop is a free-cooling loop, and operating the cooling system in the first mode is performed in response to an inlet temperature of a working fluid of the free-cooling loop below a threshold temperature. In one example of the method, operating the cooling system in the second mode is performed in response to the inlet temperature of the working fluid of the free-cooling loop above the threshold temperature.

According to at least another aspect of the present disclosure, in one example, a method of assembling a cooling system including a first heat exchanger, a second heat exchanger, an expansion valve, a pump, an expander, and a plurality of switching valves including a first switching valve, a second switching valve, a third switching valve, a fourth switching valve, a fifth switching valve, and a sixth switching valve is disclosed. The method includes: coupling the first switching valve to the first heat exchanger, the expansion valve, and the pump; coupling the second switching valve to the second heat exchanger, the expansion valve, and the pump; coupling the third switching valve to the first heat exchanger, the fourth switching valve, and the fifth switching valve; coupling the fourth switching valve to a first flow terminal of the expander and to the sixth switching valve; coupling the fifth switching valve to a second flow terminal of the expander and to the sixth switching valve; and coupling the sixth switching valve to the second heat exchanger.

In one example of the method, the method further includes communicatively coupling at least one controller of the cooling system to the plurality of switching valves, the at least one controller being configured to control the plurality of switching valves in a first configuration, including controlling the first switching valve to couple the first heat exchanger to the pump through the first switching valve, controlling the second switching valve to couple the second heater exchanger to the pump through the second switching valve, controlling the third switching valve and the fifth switching valve to couple the first heat exchanger to the second flow terminal of the expander through the third switching valve and the fifth switching valve, and controlling the fourth switching valve and the sixth switching valve to couple the second heat exchanger to the first flow terminal of the expander through the fourth switching valve and the sixth switching valve; and control the plurality of switching valves in a second configuration, including controlling the first switching valve to couple the first heat exchanger to the expansion valve through the first switching valve, controlling the second switching valve to couple the second heat exchanger to the expansion valve through the second switching valve, controlling the third switching valve and the fourth switching valve to couple the first heat exchanger to the first flow terminal of the expander through the third switching valve and the fourth switching valve, and controlling the fifth switching valve and the sixth switching valve to couple the second heat exchanger to the second flow terminal of the expander through the fifth switching valve and the sixth switching valve.

In another example of the method, the method further includes coupling the first heat exchanger to a facility-cooling loop and coupling the second heat exchanger to an equipment-cooling loop or IT equipment.

In another example of the method, the method further includes feeding an organic working fluid of the cooling system into the first heat exchanger, the second heat exchanger, the expansion valve, the pump, the expander, and the plurality of switching valves.

### BRIEF DESCRIPTION OF THE DRAWINGS

Various aspects of at least one embodiment are discussed below with reference to the accompanying figures, which may not be drawn to scale. The figures are included to provide an illustration and a further understanding of the various aspects and embodiments, and are incorporated in and constitute a part of this specification, but are not intended as a definition of the limits of any particular embodiment. The drawings, together with the remainder of the specification, serve to explain the principles and operations of the described and claimed aspects and embodiments. In the figures, each identical or substantially similar component that is illustrated in various figures may be represented by a like numeral. For purposes of clarity, not every component may be labeled in every figure. In the figures:
FIG. 1 illustrates a schematic diagram of a cooling system operating in a power generation mode according to an example;
FIG. 2 illustrates a schematic diagram of the cooling system of FIG. 1 operating in a trim cooling mode according to an example;
FIG. 3 illustrates a process to operate the cooling system of FIG. 1 according to an example; and
FIG. 4 illustrates a process to assemble the cooling system of FIG. 1 according to an example.

### DETAILED DESCRIPTION

Various heat-generating objects and machineries, such as IT equipment, may have operating temperatures within a certain range, which are incompatible with wide outside or indoor temperature fluctuations. A cooling system, such as a liquid cooling system including one or more coolant distribution units (CDUs), may be employed in a data center to provide cooling to the IT equipment, which is often densely distributed in the data center. The IT equipment may themselves be heat-generating during operation and the ambient temperature outside of the data center may also fluctuate widely over time. The liquid cooling system may stabilize the temperature of the IT equipment to be within the operating temperature range of the IT equipment even under high ambient temperatures.

In some examples, the liquid cooling system used as the primary cooling system for IT equipment in a data center may be a free-cooling system, which operates based on the outside air or ambient temperature. Because the outside air or ambient temperature may fluctuate widely over time, such as from summer to winter seasons, the free-cooling system may not be able to always maintain a stable operating temperature of the IT equipment. For example, when the ambient temperature of the data center is too high, the free-cooling system may fail to sufficiently cool the IT equipment on its own and therefore a supplemental trim cooling system may be needed. In some examples, the trim cooling system may be dormant when the outdoor temperature is sufficiently low (such as during winter or nighttime).

In various examples, it may be preferrable to not only remove the heat generated by the IT equipment as waste heat using a trim cooling system but also utilize the waste heat to generate electrical power using the same trim cooling system. Because the heat generated by the IT equipment is usually low-grade (with a heat-source temperature below, for example, 100 °C), such heat-to-electricity conversions may have very low efficiencies. When dedicated heat-recovery systems external to the trim cooling system are explored, the low efficiencies may lead to low return on investment.

Aspects of the current disclosure include a cooling system which may be used both for trim cooling and for electrical power generation using standard equipment of a typical trim cooling system. In some examples, the cooling system disclosed in the current disclosure may have a higher return on investment than that of a dedicated heat-recovery system.

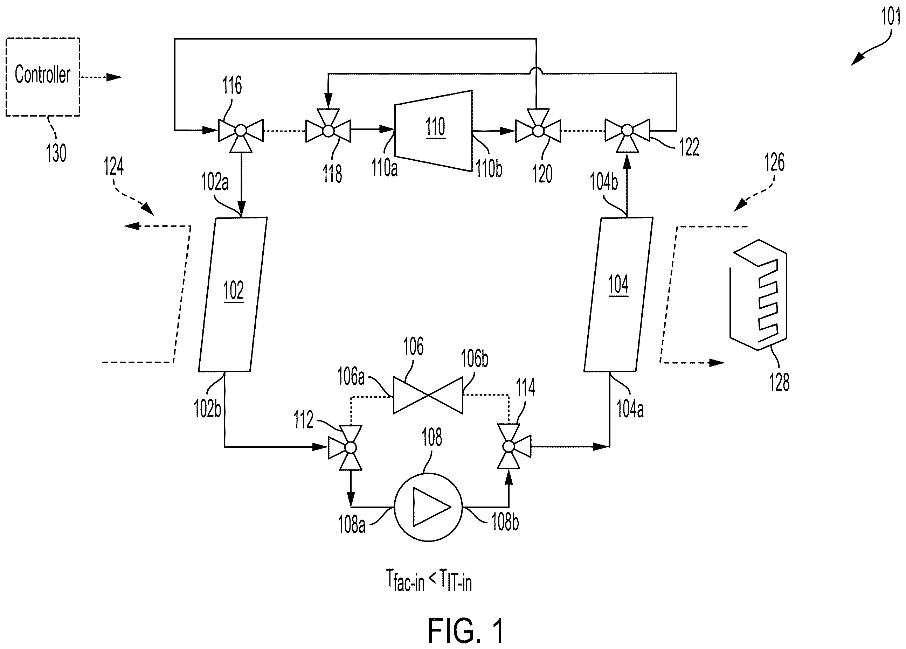

FIG. 1 illustrates a schematic diagram of a cooling system 101 operating in a power generation mode according to an example. In various examples, the cooling system 101 may be a coolant distribution unit (CDU). In one example, the cooling system 101 may include a first heat exchanger 102, a second heat exchanger 104, an expansion valve 106, a pump 108, and an expander 110. The first heat exchanger 102 may have a first inlet 102a and a first outlet 102b. The second heat exchanger 104 may have a second inlet 104a and a second outlet 104b. The expansion valve 106 may have an expansion-valve inlet 106a and an expansion-valve outlet 106b. The pump 108 may have a pump inlet 108a and a pump outlet 108b. The expander 110 may have a first flow terminal 110a and a second flow terminal 110b. In one example, when the first flow terminal 110a is used as an inlet and the second flow terminal 110b is used as an outlet, the expander 110 operates as a generator that converts heat or thermal energy into electrical power. Conversely, when the first flow terminal 110a is used as an outlet and the second flow terminal 110b is used as an inlet, that is, when the flow direction of a working fluid (or its vapor or gas) through the expander 110 is reversed, the expander 110 operates as a compressor that converts electrical power into heat or thermal energy.

In some examples, the cooling system 101 may also include a first switching valve 112, a second switching valve 114, a third switching valve 116, a fourth switching valve 118, a fifth switching valve 120, and a sixth switching valve 122. In one example, each of the switching valves 112-122 may be a three-way switching valve. The cooling system 101 may also include pipes (depicted by solid arrows and dash lines in FIG. 1) configured to interconnect or intercouple some of the equipment, for example, equipment 102-122 of the cooling system 101. The pipes depicted by solid arrows may allow the working fluid (or its vapor or gas) of the cooling system 101 (and its vapor or gas) to flow through them in the direction of the solid arrows as controlled by the respective switching valves. The pipes depicted by dash lines may not allow the working fluid (and its vapor or gas) to flow through as controlled by the respective switching valves. The cooling system 101 may also include a controller 130 communicatively coupled to the equipment 102-122 and configured to control the operation of the cooling system 101.

The first heat exchanger 102 may be configured to be coupled to a facility-cooling loop 124 to transfer heat from the first heat exchanger 102 to the facility-cooling loop 124. In some examples, the first heat exchanger 102 may be configured to be thermally coupled to the facility-cooling loop 124. In one example, the facility-cooling loop 124 may be used as a primary cooling system to provide cooling to a facility, such as a data center. In certain examples, the facility-cooling loop 124 may be a free-cooling loop that transfers heat in its coolant to the ambient air. In one example, a coolant of the facility-cooling loop 124 may be water. In some examples, the facility-cooling loop 124 may be included in the cooling system 101. In other examples, the facility-cooling loop 124 may not be included in the cooling system 101.

The second heat exchanger 104 may be configured to be coupled to an equipment-cooling loop 126 to transfer heat from the equipment-cooling loop 126 to the second heat exchanger 104. In some examples, the second heat exchanger 104 may be configured to be thermally coupled to the equipment-cooling loop 126. In one example, the equipment-cooling loop 126 may be configured to provide direct cooling to IT equipment 128 in a data center. In one example, the coolant of the equipment-cooling loop may be water. In some examples, the equipment-cooling loop 126 may be included in the cooling system 101. In other examples, the equipment-cooling loop 126 may not be included in the cooling system 101. In some examples, the second heat exchanger 104 may be configured to be directly coupled to the IT equipment to provide direct cooling to the IT equipment without using the cooling loop 126.

In certain examples, the facility cooling loop 104 may be coupled to the equipment-cooling loop through a separate heat exchanger (not illustrated). In some examples, the separate heat exchanger may be coupled to a mixing valve. In these examples, the cooling system 101 may be coupled to the separate heat exchanger to provide supplemental cooling to the equipment-cooling loop 126.

In one example, when the inlet temperature ("T_{fac-in}") of the facility-cooling loop 124 is below a required maximum inlet temperature ("T_{IT-in}") of the equipment-cooling loop 126 (that is, "T_{fac-in} < T_{IT-in}"), allowing the facility-cooling loop 124 to be capable of providing sufficient cooling to the IT equipment 128, the controller 130 may operate the cooling system 101 in a power generation mode to generate electrical power from the waste heat of the IT equipment 128.

In one example, in the power generation mode, the controller 130 may control the first switching valve 112 to couple (or connect) the first outlet 102b to the pump inlet 108a through the first switching valve 112 while keeping the first outlet 102b decoupled (or disconnected) from the expansion-valve inlet 106a. The controller 130 may also control the second switching valve 114 to couple (or connect) the pump outlet 108b to the second inlet 104a through the second switching valve 114 while keeping the expansion-valve outlet 106b decoupled (or disconnected) from the second inlet 104a. The controller may also control the third switching valve 116 and the fifth switching valve 120 to couple (or connect) the second flow terminal 110b to the first inlet 102a through the third switching valve 116 and the fifth switching valve 120 while keeping the third switching valve 116 decoupled (or disconnected) from the fourth switching valve 118 and keeping the fifth switching valve 120 decoupled (or disconnected) from the sixth switching valve 122. The controller 130 may also control the fourth switching valve 118 and the sixth switching valve 122 to couple (or connect) the first flow terminal 110a to the second outlet 104b through the fourth switching valve 118 and the sixth switching valve 122.

As described above, because the working fluid (or its vapor or gas) flows from the first flow terminal 110a to the second flow terminal 110b through the expander 110 in the power generation mode as illustrated in FIG. 1, the expander 110 may generate electrical power from the waste heat of the working fluid (or its vapor or gas) flowing out of the second outlet 104b. The expander 110 may output the generated electrical power to a load (not illustrated) coupled to the expander 110. When operating in the power generation mode, the cooling system 101 may not use a refrigeration cycle and therefore may use the pump 108 instead of the expansion valve 106 to regulate coolant flow.

In some examples, the outlet temperature at the second outlet 104b may be moderately high (for example, below 100 °C), such that the waste heat of the coolant flowing out of the second outlet 104b may be low-grade. Therefore, an organic working fluid may be used for the cooling system 101 in the power generation mode to employ an organic Rankine cycle (ORC) in the cooling system 101 to generate electrical power more efficiently from the low-grade heat. For example, various organic working fluids may be used, such as chlorofluorocarbons (CFCs), hydrochlorofluorocarbons (HCFCs), hydrofluorocarbons (HFCs), hydrocarbons (HCs), and perfluorocarbons (PFCs). In some examples, employing the ORC in the cooling system 101 as illustrated in FIG. 1 may convert at least 2-5% of the waste heat to electricity without adding complex equipment to a typical trim cooling system.

In some examples, the cooling system 101 may include a third heat exchanger (not illustrated) configured to be coupled to the equipment-cooling loop 126 and/or the second heat exchanger 104 and to be used as a regenerator in the power generation mode. In some examples, operating the regenerator may improve a power generation efficiency of the ORC.

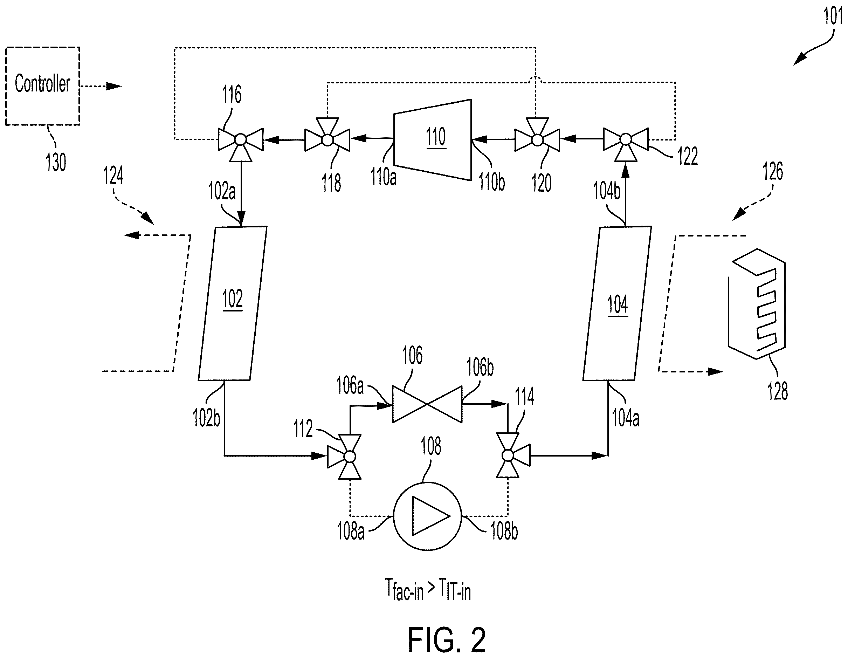

When the ambient temperature of the data center housing the IT equipment 128 increases to a certain level such that the inlet temperature ("T_{fac-in}") of the facility-cooling loop 124 is above the required inlet temperature ("T_{IT-in}") of the equipment-cooling loop 126 (that is, "T_{fac-in} > T_{IT-in}"), causing the facility-cooling loop 124 to no longer be capable of providing sufficient cooling to the IT equipment 128, the controller 130 may operate the cooling system 101 in a trim cooling mode to provide supplemental cooling to the IT equipment 128. FIG. 2 illustrates a schematic diagram of the cooling system 101 of FIG. 1 operating in a trim cooling mode according to an example.

In one example, in the trim cooling mode, the controller 130 may control the first switching valve 112 to couple (or connect) the first outlet 102b to the expansion-valve inlet 106a through the first switching valve 112 while keeping the first outlet 102b decoupled (or disconnected) from the pump inlet 108a. The controller 130 may also control the second switching valve 114 to couple (or connect) the expansion-valve outlet 106b to the second inlet 104a through the second switching valve 114 while keeping the pump outlet 108b decoupled (or disconnected) from the second inlet 104a. The controller may also control the third switching valve 116 and the fourth switching valve 118 to couple (or connect) the first flow terminal 110a to the first inlet 102a through the third switching valve 116 and the fourth switching valve 118 while keeping the third switching valve 116 decoupled (or disconnected) from the fifth switching valve 120 and keeping the fourth switching valve 118 decoupled (or disconnected) from the sixth switching valve 122. The controller 130 may also control the fifth switching valve 120 and the sixth switching valve 122 to couple (or connect) the second flow terminal 110b to the second outlet 104b through the fifth switching valve 120 and the sixth switching valve 122.

As described above, because the working fluid (or its vapor or gas) flows from the second flow terminal 110b to the first flow terminal 110a through the expander 110 in the trim cooling mode as illustrated in FIG. 2, the expander 110 may operate as a compressor and draw electrical power from a power supply (not illustrated) to provide supplemental cooling. By also engaging the expansion valve to regulate coolant flow in the trim cooling mode, the cooling system 101 may implement a refrigeration cycle to provide supplemental trim cooling to the IT equipment 128 in addition to the primary cooling from the facility-cooling loop 124.

In some examples, the cooling system 101 may operate in the trim cooling mode using the same organic working fluid as in the power generation mode. In other examples, the cooling system 101 may operate in the trim cooling mode using a different working fluid, such as an inorganic working fluid, from that in the power generation mode. When a different working fluid is needed for the cooling system 101, the existing working fluid may first be removed from the cooling system 101 before the substitute working fluid is fed into the cooling system 101.

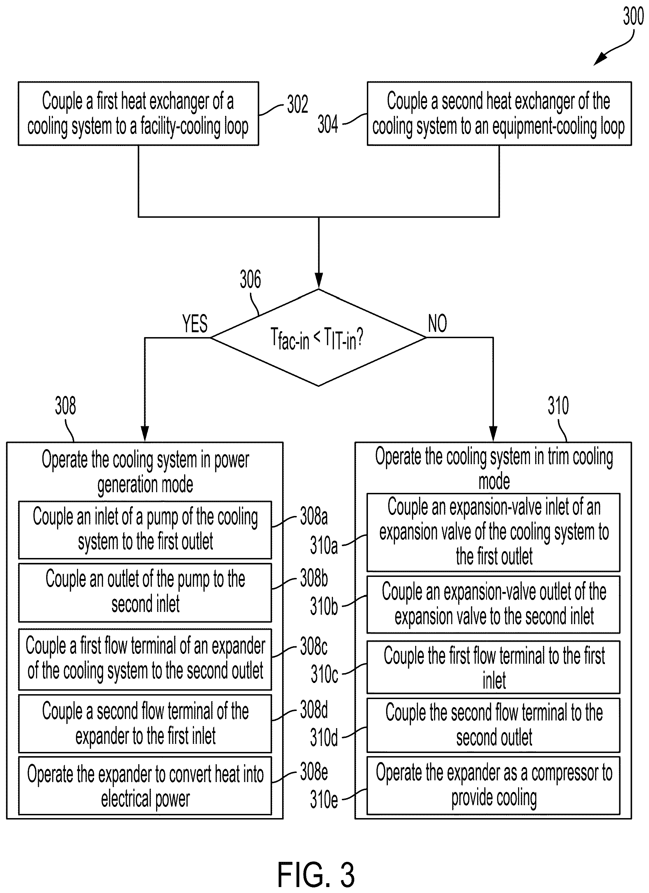

FIG. 3 illustrates a process 300 to operate the cooling system 101 according to an example. In one example, the process 300 may start by coupling the first heat exchanger 102 to the facility-cooling loop 124 at act 302 and coupling the second heat exchanger 104 to the equipment-cooling loop 126 at act 304.

At decision 306, in one example, the controller 130 may monitor the inlet temperature ("T_{fac-in}") of the working fluid of the facility-cooling loop 124 to determine whether it is below a threshold temperature. For example, the threshold temperature may be a maximum inlet temperature ("T_{IT-in}") of the equipment-cooling loop 126 required to provide sufficient cooling to the IT equipment 128. If the controller 130 determines that the inlet temperature of the facility-cooling loop 124 is below the threshold temperature (that is, "T_{fac-in} < T_{IT-in}"), the controller 130 may operate the cooling system 101 in the power generation mode at act 308.

In one example, act 308 may include sub-acts 308a, 308b, 308c, 308d, and 308e. At the sub-act 308a, in one example, the controller 130 may couple (or connect) the pump inlet 108a to the first outlet 102b. In some examples, the controller 130 may also decouple (or disconnect) the expansion-valve inlet 106a from the first outlet 102b. At the sub-act 308b, in one example, the controller 130 may couple (or connect) the pump outlet 108b to the second inlet 104a. In some examples, the controller 130 may also decouple (or disconnect) the expansion-valve outlet 106b from the second inlet 104a. At the sub-act 308c, in one example, the controller 130 may couple (or connect) the first flow terminal 110a to the second outlet 104b. In some examples, the controller 130 may also decouple (or disconnect) the first flow terminal 110a from the first inlet 102a. At the sub-act 308d, in one example, the controller 130 may couple (or connect) the second flow terminal 110b to the first inlet 102a. In some examples, the controller 130 may also decouple (or disconnect) the second flow terminal 110b from the second outlet 104b. At the sub-act 308e, in one example, the controller 130 may operate the expander 110 to convert heat into electrical power. In some examples, the cooling system 101 may use an ORC of an organic working fluid for the expander 110 to convert heat into electrical power.

At act 306, if the controller 130 determines that the inlet temperature of the facility-cooling loop 124 is not below but instead above the threshold temperature (that is, "T_{fac-in} > T_{IT-in}"), the controller 130 may operate the cooling system 101 in the trim cooling mode to provide cooling at act 310.

In one example, act 310 may include sub-acts 310a, 310b, 310c, 310d, and 310e. At the sub-act 310a, in one example, the controller 130 may couple (or connect) the expansion-valve inlet 106a to the first outlet 102b. In some examples, the controller 130 may also decouple (or disconnect) the pump inlet 108a from the first outlet 102b. At the sub-act 310b, in one example, the controller 130 may couple (or connect) the expansion-valve outlet 106b to the second inlet 104a. In some examples, the controller 130 may also decouple (or disconnect) the pump outlet 108b from the second inlet 104a. At the sub-act 310c, in one example, the controller 130 may couple (or connect) the first flow terminal 110a to the first inlet 102a. In some examples, the controller 130 may also decouple (or disconnect) the first flow terminal 110a from the second outlet 104b. At the sub-act 310d, in one example, the controller 130 may couple (or connect) the second flow terminal 110b to the second outlet 104b. In some examples, the controller 130 may also decouple (or disconnect) the second flow terminal 110b from the first inlet 102a. At the sub-act 310e, in one example, the controller 130 may operate the expander 110 as a compressor to provide cooling.

The controller 130 may execute various operations discussed above. The controller 130 may also execute one or more instructions stored on one or more non-transitory computer-readable media. The controller 130 may execute the instructions to execute various operations discussed above, including at least a portion of the process 300. In some examples, the controller 130 may include one or more processors or other types of controllers. In one example, the controller 130 is or includes at least one processor. In another example, the controller 130 performs at least a portion of the operations discussed above using an application-specific integrated circuit tailored to perform particular operations in addition to, or in lieu of, a processor. As illustrated by these examples, examples in accordance with the present disclosure may perform the operations described herein using many specific combinations of hardware and software and the disclosure is not limited to any particular combination of hardware and software components. Examples of the disclosure may include a computer-program product configured to execute methods, processes, and/or operations discussed above. The computer-program product may be, or include, one or more controllers and/or processors configured to execute instructions to perform methods, processes, and/or operations discussed above.

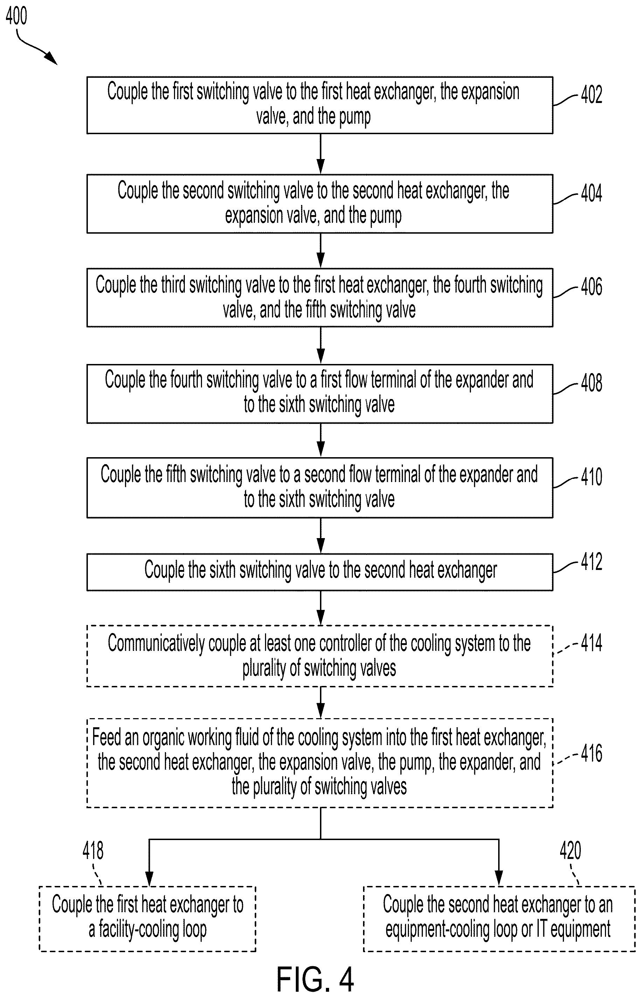

Aspects of the current disclosure also include processes for an installer or operator to assemble the cooling system 101. FIG. 4 illustrates a process 400 to assemble the cooling system 101 according to an example.

At act 402, in one example, the installer or operator may couple (or connect) the first switching valve 112 to the first heat exchanger 102, the expansion valve 106, and the pump 108. At act 404, in one example, the installer or operator may couple (or connect) the second switching valve 114 to the second heat exchanger 104, the expansion valve 106, and the pump 108. At act 406, in one example, the installer or operator may couple (or connect) the third switching valve 116 to the first heat exchanger 102, the fourth switching valve 118, and the fifth switching valve 120. At act 408, in one example, the installer or operator may couple the fourth switching valve 118 to the first flow terminal 110a of the expander 110 and to the sixth switching valve 122. At act 410, in one example, the installer or operator may couple the fifth switching valve 120 to a second flow terminal 110b of the expander 110 and to the sixth switching valve 122. At act 412, in one example, the installer or operator may couple the sixth switching valve 122 to the second heat exchanger 104.

At act 414, in one example, the installer or operator may communicatively couple the controller 130 of the cooling system 101 to the switching valves 112, 114, 116, 118, 120, and 122. In some examples, the controller 130 may also be communicatively coupled to the expander 110, the expansion valve 106, and/or the pump 108.

At act 416, in one example, the installer or operator may feed an organic working fluid of the cooling system 101 into the first heat exchanger 102, the second heat exchanger 104, the expansion valve 106, the pump 108, the expander 110, and the switching valves 112, 114, 116, 118, 120, and 122.

At act 418, in one example, the installer or operator may couple the first heat exchanger 102 to a facility-cooling loop 124. At act 420, in one example, the installer or operator may couple the second heat exchanger 104 to an equipment-cooling loop 126 or IT equipment 128.

Certain acts of the processes 300 and 400 are described as occurring in sequence solely for purposes of explanation rather than limitation. In many implementations, certain acts of the processes 300 and 400 may be executed in different orders and/or in parallel with one another. Accordingly, no limitation is implied by the order of acts in the processes 300 and 400. At least a portion of the process 300 may be implemented by the user using the controller 130.

The present disclosure may also relate to the following embodiments:
Embodiment 1. A cooling system, comprising:
   a first heat exchanger including a first inlet and a first outlet, the first heat exchanger configured to be coupled to a facility-cooling loop;
   a second heat exchanger including a second inlet and a second outlet;
   an expansion valve including an expansion-valve inlet and an expansion-valve outlet;
   a pump including a pump inlet and a pump outlet; and
   an expander including a first flow terminal and a second flow terminal, wherein
      in a first operating mode of the cooling system, the pump inlet is coupled to the first outlet, the pump outlet is coupled to the second inlet, the first flow terminal is coupled to the second outlet, the second flow terminal is coupled to the first inlet, and the expander is configured to convert heat into electric power, and
      in a second operating mode of the cooling system, the expansion-valve inlet is coupled to the first outlet, the expansion-valve outlet is coupled to the second inlet, the first flow terminal is coupled to the first inlet, the second flow terminal is coupled to the second outlet, and the expander is configured to operate as a compressor to provide cooling.
Embodiment 2. The cooling system of embodiment 1, wherein the cooling system is configured to use an Organic Rankine Cycle (ORC) in the first operating mode.
Embodiment 3. The cooling system of embodiment 2, wherein using an ORC in the first operating mode includes using an organic working fluid.
Embodiment 4. The cooling system of embodiment 3, wherein the organic working fluid includes at least one of a group including
   chlorofluorocarbons (CFCs), hydrochlorofluorocarbons (HCFCs), hydrofluorocarbons (HFCs), hydrocarbons (HCs), and perfluorocarbons (PFCs).
Embodiment 5. The cooling system of embodiment 3, wherein the cooling system is configured to use the organic working fluid in the second operating mode.
Embodiment 6. The cooling system of claim 3, wherein the cooling system is configured to use an inorganic working fluid in the second operating mode.
Embodiment 7. The cooling system of embodiment 1, wherein the facility-cooling loop is a free-cooling loop, and the cooling system is configured to operate in the first operating mode in response to an inlet temperature of a working fluid of the free-cooling loop below a threshold temperature.
Embodiment 8. The cooling system of embodiment 7, wherein the cooling system is configured to operate in the second operating mode in response to the inlet temperature of the working fluid of the free-cooling loop above the threshold temperature.
Embodiment 9. The cooling system of embodiment 8, wherein the inlet temperature of the working fluid of the free-cooling loop is determined by an ambient temperature of the free-cooling loop.
Embodiment 10. The cooling system of embodiment 7, further comprising a plurality of switching valves and at least one controller, wherein the at least one controller is configured to control the plurality of switching valves in a first configuration in response to the inlet temperature of the working fluid of the free-cooling loop below the threshold temperature.
Embodiment 11. The cooling system of embodiment 10, wherein controlling the plurality of switching valves in the first configuration includes:
   controlling a first switching valve of the plurality of switching valves to couple the pump inlet to the first outlet;
   controlling a second switching valve of the plurality of switching valves to couple the pump outlet to the second inlet;
   controlling a third switching valve of the plurality of switching valves to couple the first flow terminal to the second outlet; and
   controlling a fourth switching valve of the plurality of switching valves to couple the second flow terminal to the first inlet.
Embodiment 12. The cooling system of embodiment 10, wherein the at least one controller is configured to control the plurality of switching valves in a second configuration in response to the inlet temperature of the working fluid of the free-cooling loop above the threshold temperature.
Embodiment 13. The cooling system of embodiment 11, wherein controlling the plurality of switching valves in the second configuration includes:
   controlling the first switching valve to couple the expansion-valve inlet to the first outlet;
   controlling the second switching valve to couple the expansion-valve outlet to the second inlet;
   controlling the third switching valve to couple the first flow terminal to the first outlet; and
   controlling the fourth switching valve to couple the second flow terminal to the second inlet.
Embodiment 14. The cooling system of embodiment 1, wherein the second heat exchanger is configured to be coupled to an equipment cooling loop, the equipment-cooling loop being configured to cool IT equipment in a data center.
Embodiment 15. The cooling system of embodiment 14, wherein the cooling system is configured to provide supplementary trim cooling of the IT equipment in the second operating mode.
Embodiment 16. The cooling system of embodiment 1, wherein the second heat exchanger is configured to be coupled to IT equipment in a data center to provide cooling.
Embodiment 17. A method of operating a cooling system, comprising:
   coupling a first heat exchanger of the cooling system to a facility-cooling loop, the first heat exchanger including a first inlet and a first outlet;
   coupling a second heat exchanger of the cooling system to an equipment-cooling loop or IT equipment, the second heat exchanger including a second inlet and a second outlet;
   operating the cooling system in a first mode, including
      coupling an inlet of a pump of the cooling system to the first outlet,
      coupling an outlet of the pump to the second inlet,
      coupling a first flow terminal of an expander of the cooling system to the second outlet,
      coupling a second flow terminal of the expander to the first inlet, and
      operating the expander to convert heat into electrical power; and
   operating the cooling system in a second mode, including
      coupling an expansion-valve inlet of an expansion valve of the cooling system to the first outlet,
      coupling an expansion-valve outlet of the expansion valve to the second inlet,
      coupling the first flow terminal to the first inlet,
      coupling the second flow terminal to the second outlet, and
      operating the expander as a compressor to provide cooling.
Embodiment 18. The method of embodiment 17, wherein operating the cooling system in the first mode further comprises using an Organic Rankine Cycle (ORC).
Embodiment 19. The method of embodiment 17, wherein the facility-cooling loop is a free-cooling loop, and operating the cooling system in the first mode is performed in response to an inlet temperature of a working fluid of the free-cooling loop below a threshold temperature.
Embodiment 20. The method of embodiment 19, wherein operating the cooling system in the second mode is performed in response to the inlet temperature of the working fluid of the free-cooling loop above the threshold temperature.
Embodiment 21. A method of assembling a cooling system including a first heat exchanger, a second heat exchanger, an expansion valve, a pump, an expander, and a plurality of switching valves including a first switching valve, a second switching valve, a third switching valve, a fourth switching valve, a fifth switching valve, and a sixth switching valve, the method comprising:
   coupling the first switching valve to the first heat exchanger, the expansion valve, and the pump;
   coupling the second switching valve to the second heat exchanger, the expansion valve, and the pump;
   coupling the third switching valve to the first heat exchanger, the fourth switching valve, and the fifth switching valve;
   coupling the fourth switching valve to a first flow terminal of the expander and to the sixth switching valve;
   coupling the fifth switching valve to a second flow terminal of the expander and to the sixth switching valve; and
   coupling the sixth switching valve to the second heat exchanger.
Embodiment 22. The method of embodiment 21, further comprising communicatively coupling at least one controller of the cooling system to the plurality of switching valves, the at least one controller being configured to
   control the plurality of switching valves in a first configuration, including
      controlling the first switching valve to couple the first heat exchanger to the pump through the first switching valve,
      controlling the second switching valve to couple the second heater exchanger to the pump through the second switching valve,
      controlling the third switching valve and the fifth switching valve to couple the first heat exchanger to the second flow terminal of the expander through the third switching valve and the fifth switching valve, and
      controlling the fourth switching valve and the sixth switching valve to couple the second heat exchanger to the first flow terminal of the expander through the fourth switching valve and the sixth switching valve; and
   control the plurality of switching valves in a second configuration, including
      controlling the first switching valve to couple the first heat exchanger to the expansion valve through the first switching valve,
      controlling the second switching valve to couple the second heat exchanger to the expansion valve through the second switching valve,
      controlling the third switching valve and the fourth switching valve to couple the first heat exchanger to the first flow terminal of the expander through the third switching valve and the fourth switching valve, and
      controlling the fifth switching valve and the sixth switching valve to couple the second heat exchanger to the second flow terminal of the expander through the fifth switching valve and the sixth switching valve.
Embodiment 23. The method of embodiment 21, further comprising coupling the first heat exchanger to a facility-cooling loop and coupling the second heat exchanger to an equipment-cooling loop or IT equipment.
Embodiment 24. The method of embodiment 21, further comprising feeding an organic working fluid of the cooling system into the first heat exchanger, the second heat exchanger, the expansion valve, the pump, the expander, and the plurality of switching valves.

Having thus described several aspects of at least one embodiment, it is to be appreciated that various alterations, modifications, and improvements will readily occur to those skilled in the art. Such alterations, modifications, and improvements are intended to be part of, and within the spirit and scope of, this disclosure. Accordingly, the foregoing description and drawings are by way of example only.

## Claims

1. A cooling system, comprising:
a first heat exchanger including a first inlet and a first outlet, the first heat exchanger configured to be coupled to a facility-cooling loop;
a second heat exchanger including a second inlet and a second outlet;
an expansion valve including an expansion-valve inlet and an expansion-valve outlet;
a pump including a pump inlet and a pump outlet; and
an expander including a first flow terminal and a second flow terminal, wherein
in a first operating mode of the cooling system, the pump inlet is coupled to the first outlet, the pump outlet is coupled to the second inlet, the first flow terminal is coupled to the second outlet, the second flow terminal is coupled to the first inlet, and the expander is configured to convert heat into electric power, and
in a second operating mode of the cooling system, the expansion-valve inlet is coupled to the first outlet, the expansion-valve outlet is coupled to the second inlet, the first flow terminal is coupled to the first inlet, the second flow terminal is coupled to the second outlet, and the expander is configured to operate as a compressor to provide cooling.

2. The cooling system of claim 1, wherein the cooling system is configured to use an Organic Rankine Cycle (ORC) in the first operating mode, wherein, in particular, using an ORC in the first operating mode includes using an organic working fluid.

3. The cooling system of claim 2, wherein the organic working fluid includes at least one of a group including chlorofluorocarbons (CFCs), hydrochlorofluorocarbons (HCFCs), hydrofluorocarbons (HFCs), hydrocarbons (HCs), and perfluorocarbons (PFCs).

4. The cooling system of claim 2 or 3, wherein the cooling system is configured to use the organic working fluid or an inorganic working fluid in the second operating mode.

5. The cooling system of any one of the preceding claims, wherein the facility-cooling loop is a free-cooling loop, and the cooling system is configured to operate in the first operating mode in response to an inlet temperature of a working fluid of the free-cooling loop below a threshold temperature.

6. The cooling system of claim 5, wherein the cooling system is configured to operate in the second operating mode in response to the inlet temperature of the working fluid of the free-cooling loop above the threshold temperature, wherein, in particular the inlet temperature of the working fluid of the free-cooling loop is determined by an ambient temperature of the free-cooling loop.

7. The cooling system of claim 5 or 6, further comprising a plurality of switching valves and at least one controller, wherein the at least one controller is configured to control the plurality of switching valves in a first configuration in response to the inlet temperature of the working fluid of the free-cooling loop below the threshold temperature.

8. The cooling system of claim 7, wherein controlling the plurality of switching valves in the first configuration includes:
controlling a first switching valve of the plurality of switching valves to couple the pump inlet to the first outlet;
controlling a second switching valve of the plurality of switching valves to couple the pump outlet to the second inlet;
controlling a third switching valve of the plurality of switching valves to couple the first flow terminal to the second outlet; and
controlling a fourth switching valve of the plurality of switching valves to couple the second flow terminal to the first inlet.

9. The cooling system of claim 7 or 8, wherein the at least one controller is configured to control the plurality of switching valves in a second configuration in response to the inlet temperature of the working fluid of the free-cooling loop above the threshold temperature.

10. The cooling system of claim 8 or 9, wherein controlling the plurality of switching valves in the second configuration includes:
controlling the first switching valve to couple the expansion-valve inlet to the first outlet;
controlling the second switching valve to couple the expansion-valve outlet to the second inlet;
controlling the third switching valve to couple the first flow terminal to the first outlet; and
controlling the fourth switching valve to couple the second flow terminal to the second inlet.

11. The cooling system of any one of the preceding claims, wherein the second heat exchanger is configured to be coupled to an equipment cooling loop, the equipment-cooling loop being configured to cool IT equipment in a data center, wherein, in particular, the cooling system is configured to provide supplementary trim cooling of the IT equipment in the second operating mode.

12. The cooling system of any one of the preceding claims, wherein the second heat exchanger is configured to be coupled to IT equipment in a data center to provide cooling.

13. A method of operating a cooling system, comprising:
coupling a first heat exchanger of the cooling system to a facility-cooling loop, the first heat exchanger including a first inlet and a first outlet;
coupling a second heat exchanger of the cooling system to an equipment-cooling loop or IT equipment, the second heat exchanger including a second inlet and a second outlet;
operating the cooling system in a first mode, including
coupling an inlet of a pump of the cooling system to the first outlet,
coupling an outlet of the pump to the second inlet,
coupling a first flow terminal of an expander of the cooling system to the second outlet,
coupling a second flow terminal of the expander to the first inlet, and
operating the expander to convert heat into electrical power; and
operating the cooling system in a second mode, including
coupling an expansion-valve inlet of an expansion valve of the cooling system to the first outlet,
coupling an expansion-valve outlet of the expansion valve to the second inlet,
coupling the first flow terminal to the first inlet,
coupling the second flow terminal to the second outlet, and
operating the expander as a compressor to provide cooling.

14. The method of claim 13, wherein the facility-cooling loop is a free-cooling loop, and operating the cooling system in the first mode is performed in response to an inlet temperature of a working fluid of the free-cooling loop below a threshold temperature.

15. The method of claim 14, wherein operating the cooling system in the second mode is performed in response to the inlet temperature of the working fluid of the free-cooling loop above the threshold temperature.
